# EUROPEAN PATENT APPLICATION

(11) **EP 0 905 903 A2**
(43) Date of publication of application: **31.03.1999**
(21) Application number: 98118197.7
(22) Date of filing: 25.09.1998
(51) Int. Cl.: H03K 19/0185

(54) **Signal conversion apparatus and LSI application**

(30) Priority: 29.09.1997 JP 264341/97
(71) Applicant: NEC CORPORATION, Tokyo (JP)
(72) Inventor: Watarai, Seiichi, Minato-ku, Tokyo (JP)
(74) Representative: Betten & Resch

(57) **Abstract**

A signal conversion circuit according to the present invention comprises: a differential signal amplifier (3), a differential signal detection circuit (1), and a rated signal recognition circuit (2). The differential signal amplifier (3) receives differential signals (IN and INX ), amplifying and converting into a single signal. The differential signal detection circuit (1) receives the signal output from the differential signal amplifier, detecting the difference between the signal and a reference voltage (VR2), and the difference between the signal and a reference voltage (VR3), and then outputting the resultant signals (OUTA1 and OUTA2). The rated signal recognition circuit (2) encodes the signals (OUTA1 and OUTA2) into signals (OUT1 and OUT2). The signals (OUT1 and OUT2)together indicate the category (high level, a low level, or middle level ) of the differential signals.

## Description

The present invention relates to a signal conversion apparatus, which receives, reshapes, and converts a high, low, and middle level signals depending on their amplitudes into appropriate logical signals for a subsequent logical signal processing circuit, and an LSI (Large Scale Integration) employing it.

For the purpose of achieving high speed, reduced power consumption, and low noise, most conventional LSIs which handle logical signals utilize low-amplitude interfaces that handle signals of small amplitudes, usually not more than the power-supply voltage. Well known technologies for low-amplitude interfaces include GTL (Gunning Transceiver Logic), CTT (Center Tapped Termination), LVDS (Low Voltage Differential Signaling), and PECL (Pseudo Emitter Coupled Logic). According to PECL specifications, the necessary power-supply voltage is approximately 3V or 5V, though the amplitude of the signal is approximately 0.6V. A terminal voltage source and a terminal resistor are commonly used to supply this type of low-amplitude signal. For example, the previously cited PECL technology outputs a high level signal in the following manner: its output circuit flows a particular current through a terminal resistor to a terminal voltage source, causing the generation of an electromotive force along the terminal resistor. On the other hand, when the PECL outputs a low level signal, its output circuit flows a specific current from the terminal voltage source to the resistor, causing the generation of an electromotive force along the resistor. Therefore, the high level voltage of the generated low-amplitude signal is approximately 0.3 V higher than the terminal voltage. Correspondingly, its low level voltage is approximately 0.3 V lower than the terminal voltage. Thus, a signal amplitude of approximately 0.6V is generated.

Two commonly used approaches to low-amplitude signal transmission are the single-phase transmission and differential transmission approaches. In the single-phase transmission approach, a single low-amplitude signal is utilized for signal transmission. On the other hand, in the differential transmission approach, the low-amplitude signal and its inverse are transmitted simultaneously.

In the single-phase transmission approach, the logical level of an input signal is determined in the following manner: a reference voltage that is approximately half the input signal's amplitude is supplied to one of the two input terminals of a receiving circuit, while the signal itself goes to the other input terminal. Now, if the signal is greater than or equal to the reference voltage, it is considered a high level signal; otherwise (i.e., if the signal is less than the reference voltage), it is considered a low level signal.

On the other hand, when a signal is received in the differential transmission approach, two mutually inverse signals, as described above, are simultaneously transmitted to the two input terminals of a receiving circuit, respectively. In this approach, if the signal level at the non-inverting input terminal is higher than that at the other input terminal, namely, the inverting input terminal, it is considered a high level signal. Otherwise, if the signal received at the non-inverting input terminal is lower than that received at the inverting input terminal, it is considered as a low level signal.

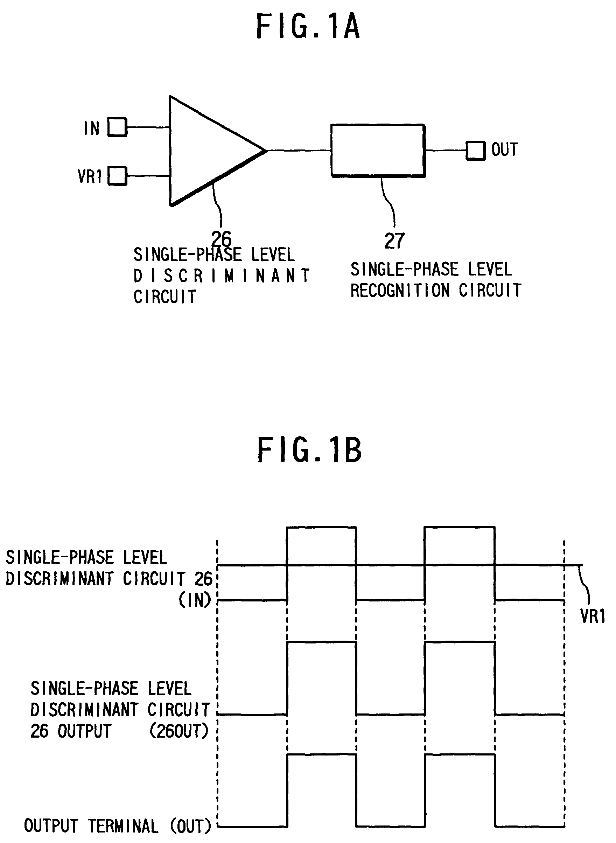

Fig. 1A shows the configuration of a conventional single-phase transmission circuit. Fig. 1B is a timing chart for the input/output signals. As shown in the circuit configuration of Fig. 1A, an input terminal (IN ) is connected to one of the input ends of a single-phase level discriminant circuit 26. A reference input terminal (VR1 ) is connected to the other input terminal of the single-level discriminant circuit 26. An output terminal of the single-phase level discriminant circuit 26 is connected to an input terminal of the single-phase level recognition circuit 27. Finally, an output terminal (OUT ) is connected to an output terminal of the single-phase level recognition circuit 27.

The operation of the conventional circuit shown in Fig. 1A will now be described with reference to the timing chart in Fig. 1B. As shown in Fig. 1B, an input signal (IN ) and a reference signal (VR1 ) are applied to the two input terminals of the single-phase level discriminant circuit 26, respectively. The single-phase level discriminant circuit 26 determines chat the input signal (IN ) is of a high level when the signal equals the reference signal(VR1 ) or is greater. Otherwise, when the signal is less than the reference signal (VR1 ), it is considered low level. The resultant 26OUT signal will then be output accordingly. The single-phase level recognition circuit 27 then receives the 26OUT signal, and outputs a logically non-inverted level signal (OUT ) corresponding to the 26OUT signal. Logical operations such as logical inversion of the OUT signal are commonly performed by the single-phase level recognition circuit 27.

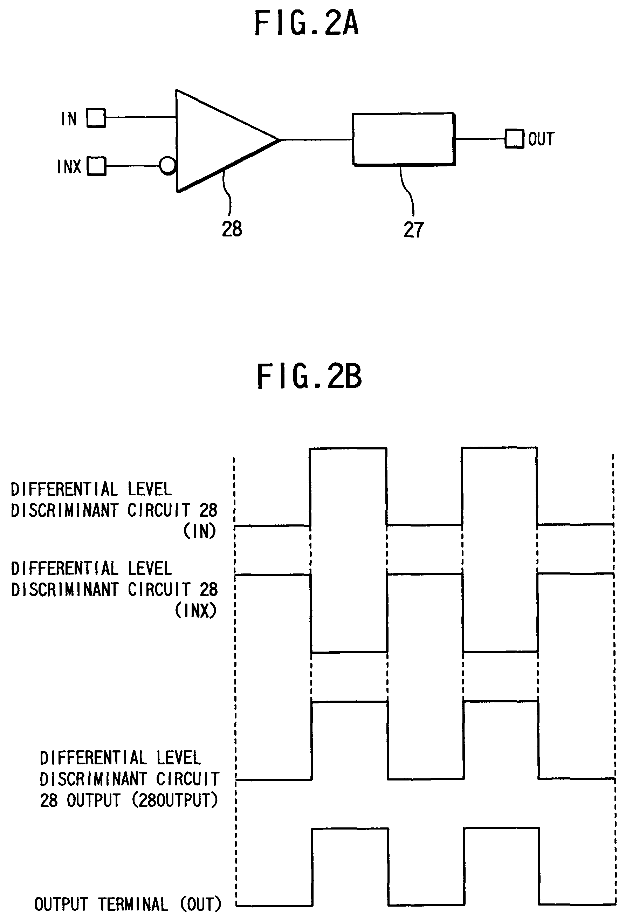

Fig. 2A shows the configuration of a conventional differential transmission circuit. Fig. 2B is a timing chart for the input/output signals. As shown in the circuit configuration of Fig. 2A, a non-inverting input terminal (IN ) is connected to one of the input terminals of a differential level discriminant circuit 28. Moreover, an inverting input terminal (INX ) is connected to the other input terminal of the differential level discriminant circuit 28. Furthermore, an input terminal of the single-phase level recognition circuit 27 is connected to the output terminal of the differential level discriminant circuit 28. An output terminal of the single-phase level recognition circuit 27 is connected to an output terminal (OUT ).

The operation of the conventional circuit in Fig. 2A will now be described with reference to the timing chart of Fig. 2B. As shown in Fig. 2B, a non-inverted input signal (IN ) and an inverted input signal (INX ) are applied to the two input terminals of the differential level discriminant circuit 28, respectively. The differential level discriminant circuit 28 considers the input signals high level when the non-inverted signal (IN ) is greater than the inverted signal (INX ). Otherwise, when the non-inverted signal (IN ) is less than the inverted signal (INX ), the input signals are considered low level. A resulting 28OUT signal will then be output. The single-phase level recognition circuit 27 then receives the 28OUT signal, and outputs a logically non-inverted level signal (OUT ) corresponding to the 28OUT signal. Logical operations such as logical inversion of the OUT signal are performed by the single-phase level recognition circuit 27.

As described above, a single-phase transmission signal or a differential transmission signal is transmitted from an output circuit, in conventional signal amplitude processing. Now, when the output circuit could transmit neither a high level signal nor a low level signal, a connected transmission line is forced to enter a high-impedance state. This state is commonly used to avoid collision with a signal output from a subsequent output circuit connected to the same transmission line.

The high-impedance state can also be entered when the connection of the output circuit and the signal transmission line is broken. On entering the high-impedance state, the level (high or low ) of the signal transmission line begins to approach the terminal power-supply voltage. In addition, the amplitude becomes zero.

A circuit receiving a low-amplitude signal definitely possesses a minimum threshold of amplitude: an input signal that falls below this level cannot be classified as high or low. The minimum threshold is referred to as a minimum rated amplitude, above which the received signal can be correctly classified by the circuit (as high or low). Thus, a signal must be transmitted with an amplitude greater than or equal to the rated amplitude value. If a signal with an amplitude less than the minimum rated amplitude is received by a receiving circuit, exact identification as to whether the signal level is high or low cannot be made, causing the output of an erroneous signal. This problem can be explained as follows, with reference to the conventional circuit in Fig. 1A: When a signal amplitude applied to the input terminal (IN ) is less than the minimum rated amplitude, the single-phase level discriminant circuit 26 cannot classify the input signal as high level or low level, resulting in the output of a middle level signal, which a subsequent circuit can neither identify as high level nor low level. Thus, when the single-phase level recognition circuit 27 receives the output signal (from the single-phase level discriminant circuit 26), it cannot identify the signal as high level or low level, and thus outputs an erroneous signal. Such erroneous signals may be generated as a result of the fact that high and low levels change randomly depending on the characteristics of the power supply of the receiving circuit, the ambient temperature, the possibly uneven quality of the receiving circuit that may arise during its manufacture, and the characteristics of other related connections. The erroneous signal may also be generated as a middle level signal that is neither high level nor low level. In the former case (in which an erroneous signal is output), an apparatus in which an LSI is embedded may malfunction due to the erroneous signal. In the latter case (in which a middle level signal is output), the transistors that make up the receiving circuit may enter an undesired conduction state, in which a large amount of steady-state current flows. This large amount of current results in an increase in power dissipation and generated heat, which, in turn, may cause the LSI and the apparatus employing it to malfunction.

The aforementioned problems may also occur in differential transmission, as shown in Figs. 2A and 2B. In the high-impedance state, signal amplitude is zero, which is below the minimum rated amplitude. Therefore, the same problems as described above may occur.

### SUMMARY OF THE INVENTION

The present invention was devised taking the aforementioned problems of conventional technologies into consideration. Thus, the objective of the present invention is to provide a signal conversion apparatus which prevents the aforementioned problems from occurring due to middle level signals (i.e., signals which cannot be identified as high level or low level), and prevents the transistors of a receiving circuit from entering undesired conduction states. This results in the prevention of an increase in dissipation power and generated heat caused by a large amount of current.

According to an aspect of the present invention, a signal conversion apparatus is provided, comprising: a differential signal detection circuit detecting a first difference between a signal and a first reference voltage, and a second difference between the signal and a second reference voltage, respectively; and an encoding circuit encoding the first and second differences into given code signals, respectively.

According to another aspect of the present invention, a signal conversion apparatus is provided, comprising: a signal conversion circuit converting differential signals into a single signal; a differential signal detection circuit detecting a first difference between the signal converted by the signal conversion circuit and a first reference voltage, and a second difference between the signal converted by the signal conversion circuit and a second reference voltage, respectively; and an encoding circuit encoding the first and second differences into given code signals, respectively.

According to yet another aspect of the present invention, an amplitude signal processing method is provided, comprising: a differential signal amplitude detection step of detecting the voltage difference between an input signal and the input signal's inverse, namely, the difference of their amplitudes, and outputting a resulting differential signal; a differential signal detection step of detecting the differences between the differential signal and a first reference voltage, and between the differential signal and a second reference voltage, respectively, and outputting resulting differential signals; a rated signal identification step of receiving the differential signals, identifying the input signal as high level or low level, determining that the amplitude of the input signal is less than a given minimum rated amplitude, and also outputting a resultant signal.

According to yet another aspect of the present invention, the aforementioned amplitude signal processing method further comprises a signal amplification step of amplifying, by a given factor, an input signal, even if the signal amplitude is less than the minimum rated amplitude.

The present invention with the aforementioned configurations provides the following excellent results: whether the amplitude of an input signal in a high-impedance state is below the minimum rated amplitude is determined, in addition to the determination of the input signal level as high or low. This enables the successful detection of a high-impedance state, in which the signal amplitude is zero. Accordingly, malfunctions that may arise as a result of a high-impedance state will be prevented. Moreover, an indication signal corresponding to the high-impedance state will be generated.

### BRIEF DESCRIPTION OF DRAWINGS

Other features and advantages of the invention will be made more apparent by the detailed description that follows, taken in conjunction with the accompanying drawings, wherein:
Figs. 1A and 1B show a conventional circuit structure and its operation, respectively;
Figs. 2A and 2B show a conventional circuit structure and its operation, respectively;
Fig. 3 shows the circuit configuration of a first embodiment;
Fig. 4 shows the configuration of a differential signal detection circuit;
Figs. 5A and 5B show the configuration of a rated signal recognition circuit and a function table for a rated signal recognition circuit, respectively;
Fig. 6 is a timing chart showing the action of the first embodiment;
Figs. 7 shows the configuration of a second embodiment;
Fig. 8 shows the configuration of a differential signal amplification circuit; and
Figs. 9A, 9B, and 9C show the configuration of application circuits, basic wave forms of a transmitted signal, and a wave form in a high-impedance state, respectively.

### DETAILED DESCRIPTION OF THE PREFERRED EMBODIMENTS

A first embodiment of the present invention will be described in detail hereafter with reference to the drawings.

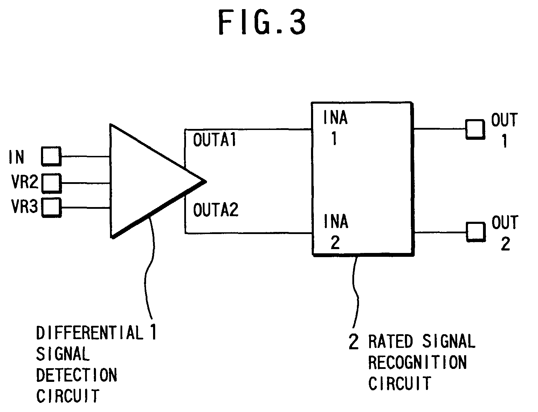

Fig. 3 shows the configuration of a first embodiment of the present invention. The first embodiment is made up of a differential signal detection circuit 1 and a rated signal recognition circuit 2. The differential signal detection circuit 1 comprises an input terminal IN, two reference voltage input terminals VR2 and VR3, and two output terminals OUTA1 and OUTA2. The rated signal recognition circuit 2 comprises two input terminals INA1 and INA2, and two output terminals OUT1 and OUT2. The differential signal detection circuit 1 detects the differences between an input signal and a reference voltage VR2, and between the input signal and a reference voltage VR3, outputting resultant differential signals OUTA1 and OUTA2. The rated signal recognition circuit 2 then encodes the differential signals OUTA1 and OUTB2 into signals OUT1 and OUT2, which together indicate whether the input signal is categorized as high level, low level, or middle level.

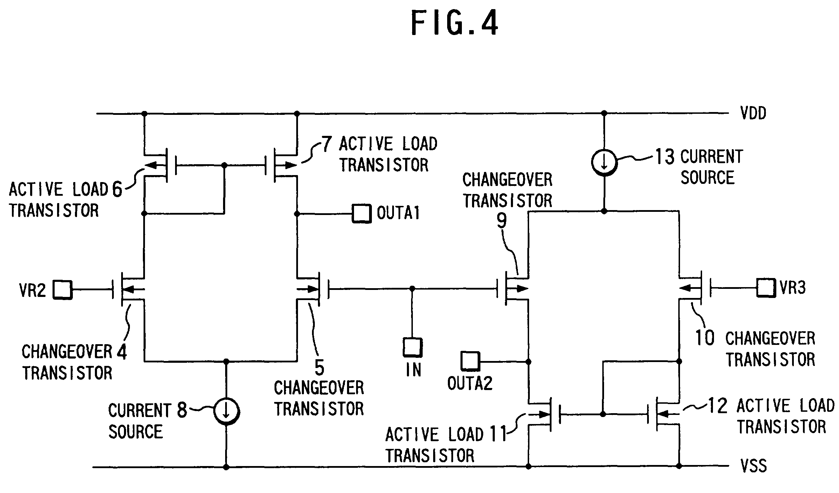

Fig. 4 shows the configuration of a differential signal detection circuit 1. As shown in Fig. 4, the differential signal detection circuit 1 is made up of: current sources 8 and 13, which supply currents through respective active load transistors 6, 7, 11, and 12; and changeover transistors 4, 5, 9, and 10, which control whether the respective currents will flow or not.

The sources of active load transistors 6 and 7, which are PMOS-type transistors, are both connected to a power-supply voltage VDD, while their gates are both connected to the drain of the active load transistor 6. The drains of the respective changeover transistors 4 and 5, which are NMOS-type transistors, are connected to the drains of the transistors 6 and 7, respectively, while their sources are both connected to the current source 8. The sources of the active load transistors 11 and 12, which are NMOS-type transistors, are both connected to a power-supply voltage VSS, while their gates are both connected to the drain of the transistor 12. The drains of the changeover transistors 9 and 10, which are PMOS transistors, are connected to the drains of the transistors 11 and 12, respectively, while their sources are both connected to the current source 13. The gates of the changeover transistors 5 and 9 are connected to each other, and an input terminal is placed at their junction. Reference voltage input terminals VR2 and VR3 are placed at the gates of the changeover transistors 4 and 10, respectively. Output terminals OUTA1 and OUTA2 are placed at the drains of the transistors 5 and 9, respectively.

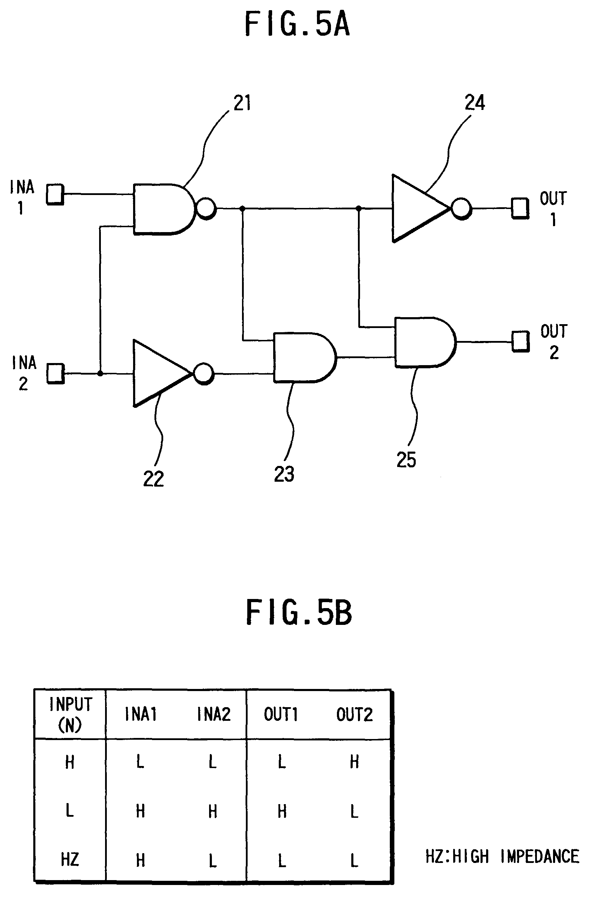

Fig. 5A shows the configuration of the rated signal recognition circuit 2 in Fig. 3. As shown in Fig. 5A, the rated signal recognition circuit 2 comprises logic circuits 21 to 25, outputting logical category signals (OUT1 and OUT2 ) indicating a high level, low level, or high impedance level. The AND circuit 21 has two input terminals INA1 and INA2, whose logical output is fed into one of the input terminals of an AND circuit 23 and one of the input terminals of an AND circuit 25. In addition, the output of the AND circuit 21 is also fed into an inverter 24, which then outputs its inverted signal to the output terminal OUT1. A signal received through the input terminal INA2 is inverted by the inverter 22, and then output to the other input terminal of the AND circuit 23. The output from the AND circuit 23 is sent to the other input terminal of the AND circuit 25, whose output goes to the output terminal OUT2.

Fig. 5B is a function table showing the operations of the differential signal detection circuit 1 and rated signal recognition circuit 2. As shown in Fig. 5B, when a high level or a low level signal is input (IN; see Fig. 3 ), complementary logical signals are output through the two terminals OUT1 and OUT2. However, when a high-impedance level (HZ ) signal is input, specifically when an input signal amplitude is below the minimum rated amplitude (i.e., the signal falls between the reference voltages VR2 and VR3 ) of the differential signal detection circuit 1, low level signals are output through both terminals OUT1 and OUT2.

An apparatus with the configuration of the Fig. 5A can prevent malfunctions caused by receiving a signal in a high-impedance state.

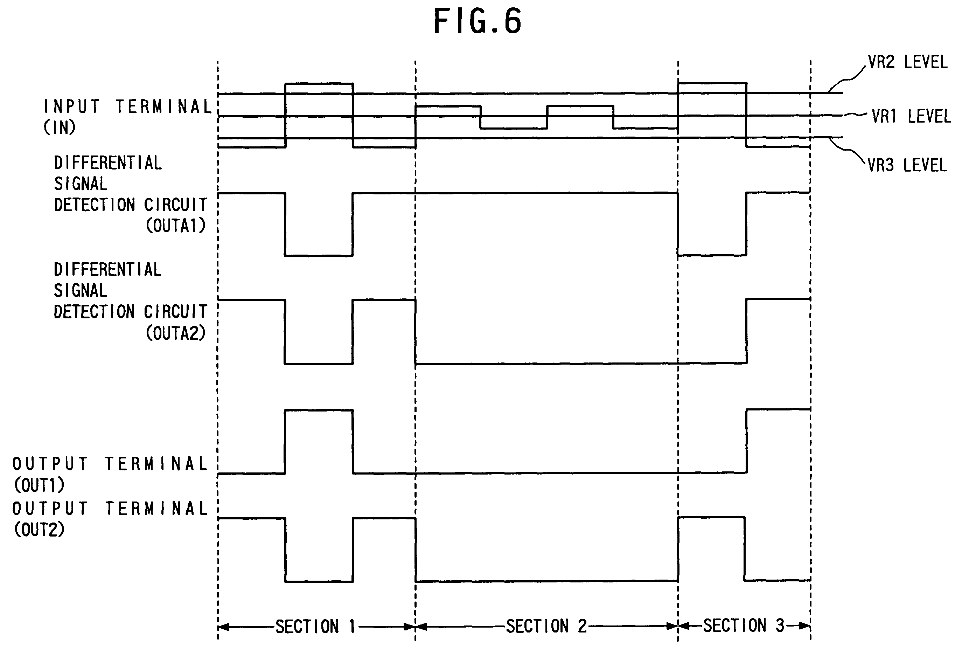

Next, the operation of the first embodiment according to the present invention will be described below with reference to Fig. 6.

The two reference voltages VR2 and VR3 shown in Fig. 6 (also shown in Figs. 3 and 4 ) are set in such a way that the difference between VR2 and VR3 is equal to the minimum rated amplitude, and VR2 > VR3. When set in this manner, VR2 corresponds to a logical high level threshold, while VR3 corresponds to a logical low level threshold for the differential signal detection circuit 1. When the signal on the input terminal IN changes and crosses both reference voltages VR2 and VR3, logical levels that are the inverse of the signal passing through the input terminal IN will be output from the two output terminals OUTA1 and OUTA2, respectively. This operation is shown in sections 1 and 3 (Fig. 6). This operation will be made when the amplitude of the input signal IN is equal to or greater than the minimum rated amplitude of the differential signal detection circuit 1. However, when the amplitude of the input signal is less than the minimum rated amplitude (which specifically corresponds to section 2 in Fig. 6 ) or, in other words, when the input signal is less than one of the reference voltages (specifically, VR2) but is equal to or greater than the other (specifically, VR3), the signal (whose amplitude may therefore be slight ) does not cross the reference voltages VR2 and VR3. This causes no change in the two outputs OUTA1 and OUTA2 of the differential signal detection circuit 1 in Fig. 4; that is, OUTA1 and OUTA2 continuously output the same respective high or low level signals. The outputs OUTA1 and OUTA2 are coupled to the input terminals INA1 and INA2 in the rated signal recognition circuit 2 in Fig. 5A, respectively. The function table in Fig. 5B makes clear that the outputs OUT1 and OUT2 behave in a manner shown in the timing chart in Fig. 6. Specifically, the outputs OUT1 and OUT2 within sections 1 and 3 of the timing chart in Fig. 6 are shown in the first two rows of the function table in Fig. 5B (for the case in which high or level input signals have been entered ). The outputs OUT1 and OUT2 within section 2 of the timing chart in Fig. 6 are shown in the last row of the function table in Fig. 5B (for the case in which the input signal is in a high impedance state ).

### SECOND EMBODIMENT

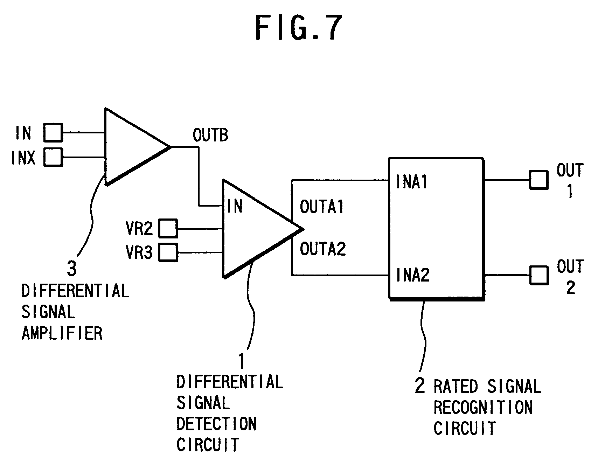

Next, the circuit configuration of a second embodiment of the present invention will be described with reference to Fig. 7.

The second embodiment relates to a signal amplification circuit which receives and amplifies a differential signal in a differential transmission approach. Fig. 7 shows an example configuration of the circuit. The signal amplification is very useful when the difference between the amplitude of an input signal and the minimum rated amplitude of the signal detection circuit is small so that detection of whether the input signal's amplitude is less than the minimum rated amplitude cannot be made, owing to the low resolution of the signal detection circuit.

As shown in Fig. 7, the second embodiment comprises: the differential signal detection circuit 1 and the rated signal recognition circuit 2 of the first embodiment; and a differential signal amplifier 3 as a differential signal detection and amplification means, with a non-inverting input terminal IN, an inverting input terminal INX, and an output terminal OUTB. The differential signal detection circuit 1 receives a signal from the output terminal OUTB of the differential signal amplifier 3 via the input terminal IN of the circuit 1.

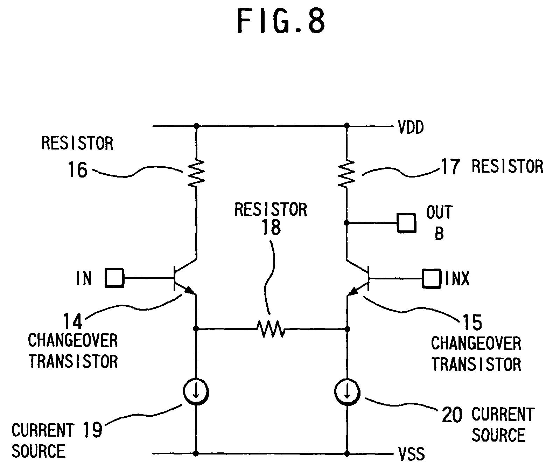

Fig. 8 shows an example configuration of the differential signal amplification circuit 3. As shown in Fig. 8, the differential signal amplification circuit 3 comprises: resistors 16 and 17; constant-current sources 19 and 20, which supply current to the respective resistors; and changeover transistors 14 and 15, which control whether respective currents will flow. The collector of the changeover transistor 14, whose base is connected to a non-inverting input terminal IN, is connected to a power-supply voltage VDD, via the resistor 16. The emitter of the transistor 14 is connected to a power-supply voltage VSS, via the constant-current source 19. In addition, an inverting input terminal INX is connected to the base of the transistor 15, and an output terminal OUTB is placed at the collector of the transistor 15. The collector of the transistor 15 is connected to the power-supply voltage VDD; the emitter is connected to the power-supply voltage VSS. The emitters of the transistors 14 and 15 are connected to each other via the resistor 18. Explanations for the differential signal detection circuit 1 and the rated signal recognition circuit 2 are omitted since these circuits 1 and 2 have configurations identical to those described in the first embodiment.

The operation of the second embodiment according to the present invention will now be described. Subsequent operations after the differential signal amplification circuit 3 has amplified each input signal received at the non-inverting input terminal IN and the inverting input terminal INX, are identical to those of the first embodiment. The signal amplification factor will be easily determined by adjusting either the constant currents flowing through the resistors 16 and 17 in the differential signal amplification circuit 3, which are provided by the current sources 19 and 20, or adjusting the electrical resistance of the resistors 16 and 17.

With the aforementioned amplification operation, the difference between the amplitude of a normal input signal and the minimum rated amplitude will become greater. The reference voltage VR2 of the differential signal detection circuit 1 is therefore set to the mean of the maximum voltage of the normal input signal and a voltage A2, where the difference between A2 and a voltage A3 is equal to the minimum rated amplitude, and A2>A3; similarly, the reference voltage VR3 of the differential signal detection circuit 1 is set to the mean of the minimum voltage of the normal input signal and a voltage A3 as described above.

Note that when the amplification factor of the differential signal amplification circuit 3 of the aforementioned second embodiment is determined to be 1, no actual amplification will be made. In addition, when the second embodiment is used as a single-phase based transmission unit with an amplification function, the inverting input terminal (INX ) functions as a reference input terminal (VR1 ), while the non-inverting input terminal (IN ) retains its function as the terminal into which an input signal, a single-phase transmission signal in this case, is provided.

The circuit configurations of the single-phase level differential detection circuit 1, the differential signal amplification circuit 3, and the rated signal recognition circuit are shown in Figs. 3, 4, and 5. However, these are merely the simplest configurations, used for the sake of making the explanation about circuit operations understandable. Actually, any configuration may be allowed as long as it behaves according to the timing chart of Fig. 6. For example, each bipolar transistor can be replaced by a MOS-type transistor, or vice versa. Each transistor can also be replaced by a MOS-transistor, or other related active device. These replacements are well known.

As for the function table of Fig. 5B, the output signals OUT1 and OUT2 together indicate the logical level of the input signal, i.e., whether the input signal level is high, low or high-impedance. However, the exact logic values of the OUT1 and OUT2 signal levels relative to the input signal level can be different from those shown in Fig. 5B, as long as distinction among the low, high, and high-impedance levels can be clearly made. Accordingly, the logic in the timing chart of Fig. 6 can be modified to reflect the output logic of OUT1 and OUT2 in the function table.
Correspondingly, the logic of the differential detection circuit, the signal amplification circuit, and the rated signal recognition circuit should also be modified. These changes can be easily made.

### THIRD EMBODIMENT

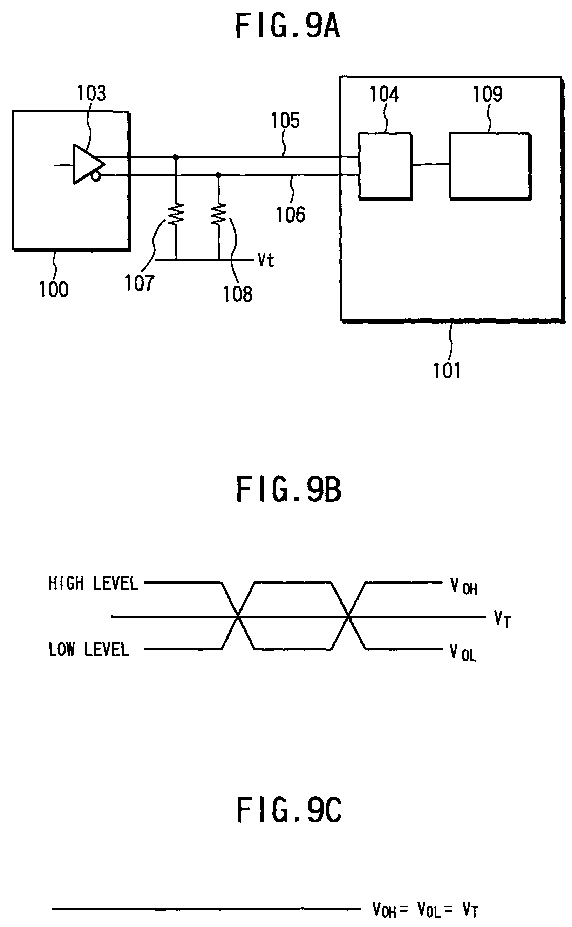

In a third embodiment of the present invention, an application of the aforementioned first and second embodiments will be described with reference to Figs. 9A, 9B, and 9C.

Fig. 9A shows the configuration of the application. In the application, the differential signal processing circuit (see Fig. 7 ) according to the second embodiment of the present invention is utilized as an interface unit in an LSI 101. In Fig. 9A, an LSI 100 transmits a signal to an LSI 101 via a differential signal outputting circuit 103 and communication lines 105 and 106, in accordance with the LVDS (Low Voltage Differential Signaling ) standard. Terminating resistors 107 and 108 are connected to the communication lines 105 and 106, respectively. The other ends of the terminating resistors 105 and 106 are both connected to a terminating voltage Vt. The communication lines 105 and 106 are used as a non-inverting signal line and an inverting signal line, respectively.

A differential signal processing circuit 104 in the LSI 104 is configured in the same manner as the circuit in Fig. 7. The differential signal processing circuit 104 receives a differential signal transmitted from the LSI 100. Note that the communication lines 105 and 106 may enter a high-impedance state. The differential signal processing circuit 104 operates in the same manner as explained in the second embodiment section, outputting a category signal for a high, low, or high-impedance level, which corresponds to the output signals OUT1 and OUT2 in Fig. 7. The category signal is then sent to a CMOS-type internal circuit 109.

Figs. 9B and 9C show a basic wave form output from the differential signal outputting circuit 103, and a wave form in a high-impedance state, respectively.

With the LSI 101 configured in this manner, the internal circuit 109 will never receive a signal in a high-impedance state (i.e., a middle level signal). This prevents an increase in dissipation power and malfunctions due to a middle level signal.

In the third embodiment, the second embodiment is used in a CMOS-type LSI. Naturally, it can also be used in other types of LSIs such as PMOS-type, NMOS-type, Bi-CMOS type, and Bipolar-type LSIs.

Furthermore, in the third embodiment, the signal is transmitted in accordance with the LVDS standard. Naturally, the signal can also be transmitted in accordance with other standards such as the RS232C, RS422, TTL (Transistor-Transistor Logic ), CMOS, GTL, CTT, and PECL standards, or other related connections.

### RESULTS OF THE EMBODIMENTS

The circuit configurations according to the first to third embodiments of the present invention have the following beneficial results:

First, since a signal transmitted via a transmission line is identified as high level, low level, or high-impedance level (the middle level), and these levels are output, no erroneous signals are produced. This prevents malfunctions in an LSI or any other apparatus that receives the level signal. Specifically, since a middle level signal, which can neither be identified as a high or a low level signal, is never output, unnecessary activation of the transistors that make up a receiving circuit will be avoided, thus preventing an increase in dissipation power and calorific value.

Secondly, even though the amplitude of a transmitted signal is much greater or much less than the minimum rated amplitude, similar results as described earlier will be achieved by the aforementioned operation.

Thirdly, the operation is generalized for low-amplitude signal transmission approaches. Thus, the operation can be applied to the single-phase transmission and differential transmission approaches, resulting in the aforementioned beneficial results.

Lastly, even though the difference between the amplitude of a transmitted signal and the minimum rated amplitude is small, it will be amplified by a given factor through the signal amplification operation, resulting in the aforementioned beneficial results.

Note that as many apparently widely different embodiments of the present invention can be made without departing from the spirit and scope thereof, it is to be understood that the invention is not limited to the specific embodiments thereof; except as defined in the appended claims.

## Claims

1. A signal conversion apparatus, comprising:
a differential signal detection circuit detecting a first difference between a signal and a first reference voltage, and a second difference between the signal and a second reference voltage, respectively;
and an encoding circuit encoding the first and second differences into given code signals, respectively.

2. The signal conversion apparatus according to claim 1, wherein: the first and second reference voltages denote a given minimum threshold voltage and maximum threshold voltage, respectively; and the range between the first and second reference voltages covers middle voltage signals or a high-impedance state.

3. The signal conversion apparatus according to claim 1, wherein the encoding circuit encodes the first and second differences in such a way that: codes L and H correspond to a high level input signal; codes H and L correspond to a low level input signal; and codes L and L correspond to a high-impedance state.

4. The signal conversion apparatus according to claim 1, wherein the differential signal detection circuit is comprised of at least two differential amplifiers used to detect the first and second differences, respectively.

5. The signal conversion apparatus according to claim 1, wherein the differential signal detection circuit is made up of MOS-type transistors.

6. A signal conversion apparatus, comprising:
a signal conversion circuit converting differential signals into a single signal;
a differential signal detection circuit detecting a first difference between the signal converted by the signal conversion circuit and a first reference voltage, and a second difference between the signal converted by the signal conversion circuit and a second reference voltage, respectively;
and an encoding circuit encoding the first and second differences into given code signals, respectively.

7. The signal conversion apparatus according to claim 6, wherein: the first and second reference voltages denote a given minimum threshold voltage and maximum threshold voltages, respectively; and the range between the first and second reference voltages covers middle voltage signals or a high-impedance state.

8. The signal conversion apparatus according to claim 6, wherein the encoding circuit encodes the first and second differences in such a way that: codes L and H correspond to a high level input signal; codes H and L correspond to a low level input signal; and codes L and L correspond to a high-impedance state.

9. The signal conversion apparatus according to claim 6, wherein the differential signal detection circuit is composed of at least two differential amplifiers used to detect the first and second differences, respectively.

10. The signal conversion apparatus according to claim 6, wherein the differential signal detection circuit is made up of MOS-type transistors.

11. The signal conversion apparatus according to claim 6, wherein the differential signals are dependent upon the LVDS (Low Voltage differential Signaling ) standard.

12. The signal conversion apparatus according to claim 6, wherein the differential signals are dependent upon the RS422 standard, the PECL (Pseudo Emitter Coupled Logic ) standard, the RS232C standard, or the TTL (Transistor Logic ) standard.

13. An amplitude signal processing method, comprising:
a differential signal amplitude detection step of detecting the voltage difference between an input signal and the input signal's inverse, namely, the difference of their amplitudes, and outputting a resulting differential signal;
a differential signal detection step of detecting the differences between the differential signal and a first reference voltage, and between the differential signal and a second reference voltage, respectively, and outputting resulting differential signals;
a rated signal identification step of receiving the differential signals, identifying the input signal as high level or low level, determining that the amplitude of the input signal is less than a given minimum rated amplitude, and also outputting a resultant signal.

14. The amplitude signal processing method according to claim 13, further comprising: a signal amplification step of amplifying, by a given factor, an input signal, even if the signal amplitude is less than the minimum rated amplitude.
